# EUROPEAN PATENT APPLICATION

(11) **EP 0 568 311 A2**
(43) Date of publication of application: **03.11.1993**
(21) Application number: 93303270.8
(22) Date of filing: 27.04.1993
(51) Int. Cl.: H05K 3/46, H05K 3/40, H01R 9/09

(54) **A method of manufacturing a multilayer printed wiring board**

(30) Priority: 01.05.1992 JP 140016/92
(71) Applicant: Nippon CMK Corp., Iruma-Gun Saitama (JP)
(72) Inventor: Kawakami, Shin, c/o Nippon CMK Corp., Iruma-gun, Saitama (JP)
(74) Representative: Boydell, John Christopher

(57) **Abstract**

A method of manufacturing a multilayer printed wiring board is disclosed. In the disclosed method, respective layers of a multilayer printed wiring board are formed with respective printed wiring boards (1, 4, 6), respective printed wiring boards are laminated and pasted up, and necessary circuits of the printed wiring board are electrically connected by means of through holes punched into the respective printed wiring boards. The method comprises the steps of: making the outer diameter of a connecting land (8,9) of the printed wiring board positioned at an inner layer of the respective printed wiring boards forming respective layers, larger than through hole (13,14) diameter of connecting lands (10,11) of the printed wiring board positioned at an outer layer of the respective printed wiring boards; making the through hole (13,14) diameter of connecting lands (10,11) of the printed wiring board positioned at an outer layer of the respective printed wiring boards larger than the through hole (12) diameter of the connecting lands (8,9) of the printed wiring board positioned at an inner layer of the respective printed wiring boards; inserting a plurality of fine wires (16) into respective through holes punched in the respective printed wiring boards; filling up solder (17) into the through holes of the connecting lands by capillary action; and electrically connecting necessary circuits between the respective printed wiring boards with each other.

## Description

The present invention relates to a method of manufacturing a multilayer printed wiring board.

In known printed wiring boards, high densifying of printed wiring circuits and downsizing of the printed wiring board itself are promoted and to this end the development from double sided printed wiring board to the multilayer printed wiring board is well advanced.

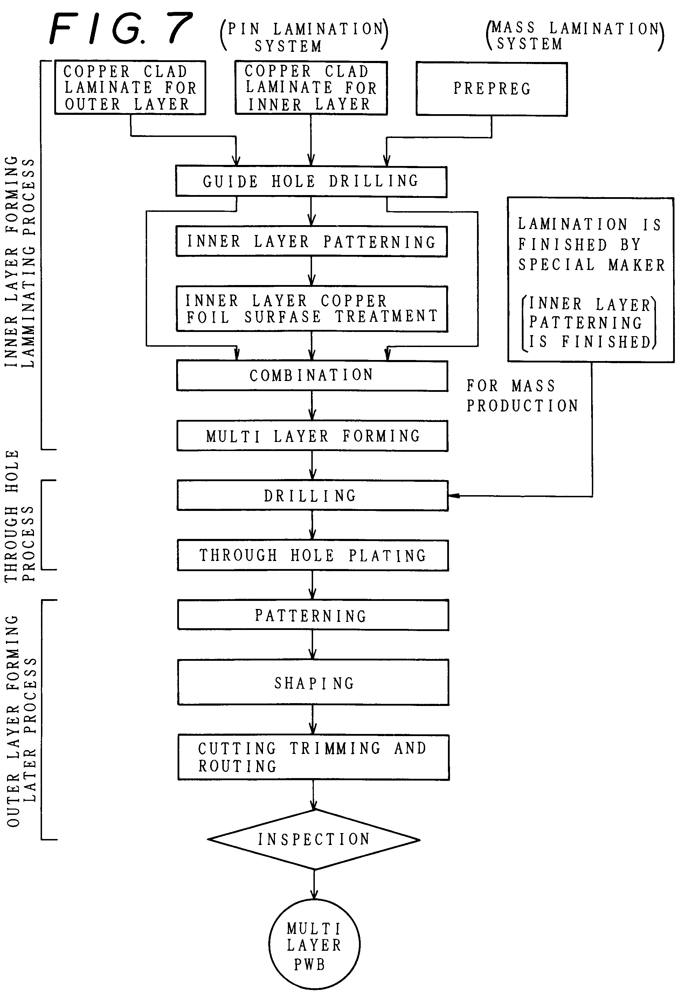

The manufacture of multilayer printed wiring board comprises an inner layer forming process, a laminating process, a through hole process, an outer layer forming process and a later process as shown in Figure 7 of the accompanying drawings.

In the method of manufacturing multilayer printed wiring board, in order to connect respective layers, the method of connecting respective layers by means of the through hole is adopted and in practice, as shown in Figure 7, through hole plating by means of copper electroless deposition or plating and copper electroplating is used.

In the connecting method using through hole plating, however, the plating apparatus itself becomes large, the cost of equipment becomes large and, at the same time, the working environment deteriorates, severe requirements are imposed on the control of the plating solution itself and there are a number of problems, such as the problem of environment, for example draining treatment or the like.

The present invention seeks to overcome the above-described disadvantages of the method of manufacturing multilayer printed wiring board, and to provide a method of manufacturing multilayer printed wiring board, in which the manufacture thereof is made simple, with low price and improved reliability and quality.

According to the present invention, there is provided a method of manufacturing multilayer printed wiring board in which respective layers of a multilayer printed wiring board are formed with respective printed wiring boards, respective printed wiring boards are laminated and pasted up, and necessary circuits of the printed wiring board are electrically connected by means of through holes punched into respective printed wiring boards, the method comprising steps of: making the outer diameter of a connecting land of the printed wiring board positioned at an inner layer of the respective printed wiring boards forming respective layers, larger than the through hole diameter of connecting lands of the printed wiring board positioned at an outer layer of the respective printed wiring boards; making the through hole diameter of connecting lands of the printed wiring board positioned at an outer layer of the respective printed wiring boards larger than the through hole diameter of the connecting land of the printed wiring board positioned at an inner layer of the respective printed wiring boards; inserting a plurality of fine wires into respective through holes punched in the respective printed wiring boards; filling up solders in the through holes of the connecting lands by a capillary phenomenon; and electrically connecting necessary circuits between the respective printed wiring boards with each other.

According to the method of manufacturing multilayer printed wiring board of the present invention, the conduction of the through holes is performed by inserting a plurality of fine wires into respective through holes punched in the respective printed wiring boards, so that disadvantages due to through hole plating are eliminated and multilayer printed wiring board can be provided with low price and high reliability.

In order that the invention may be better understood, several embodiments thereof will now be described by way of example only and with reference to the accompanying drawings in which:-
Figure 1 is a partially expanded sectional view of a multilayer printed wiring board showing a method of manufacturing a multilayer printed wiring board according to the present invention;
Figure 2 is a sectional view showing a modification of fine wires shown in Figure 1;
Figure 3 is a sectional view showing another modification of fine wires shown in Figure 1;
Figure 4 is a sectional view showing another modification of fine wires shown in Figure 1;
Figure 5 is a sectional view showing a further modification of fine wires shown in Figure 1;
Figure 6 is a side view of an electronic component showing an embodiment in case of using the fine wires and lead wire of electronic component in combination; and
Figure 7 is an explanatory view showing a conventional method of manufacturing multilayer printed wiring board.

Referring to the drawings, there are shown various embodiments of a method of manufacturing multilayer printed wiring board according to the present invention.

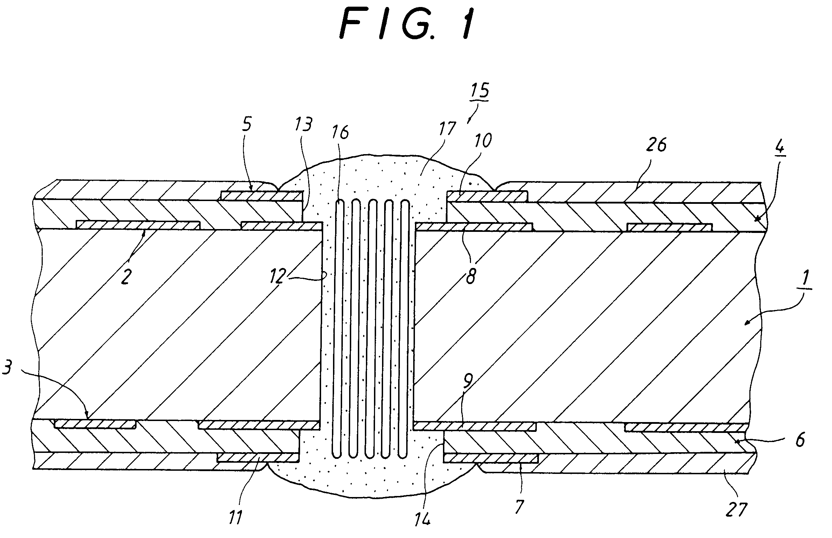

Figure 1 is a partially expanded sectional view of a multilayer printed wiring board showing an embodiment of the present invention.

In Figure 1, reference numeral 1 is a printed wiring board positioned at an inner layer on which a printed wiring circuit 2 as a first layer and a printed wiring circuit 3 as a second layer, are respectively formed on its upper surface and lower surface and hereinafter referred to as an inner layer printed wiring board. Reference numeral 4 is a printed wiring board positioned at the upper outer layer of a printed wiring board 1 and on which a third laminated layer of a printed wiring circuit 5 is formed and hereinafter referred to as a first outer layer printed wiring board. Reference numeral 6 is a printed wiring board positioned at the lower layer of the inner layer printed wiring board 1 on which a fourth laminated layer of a printed wiring circuit is formed.

The connecting lands 8, 9, 10 and 11 for electrically connecting respective printed wiring circuits 2, 3, 5 and 7 with each other are arranged on the inner and outer layer printed wiring boards 1, 4 and 6, at the corresponding positions in the circuit patterns of the respective printed wiring circuits 2, 3, 5 and 7, and respective connecting lands 8, 9, 10 and 11 are provided with through holes 12, 13 and 14 at the centre portions thereof respectively by punching out by drilling, thereby providing respective inner and outer layer printed wiring boards 1, 4 and 6.

In order to form the respective connecting lands 8, 9, 10 and 11 and respective through holes 12, 13 and 14 of the inner and outer layer printed wiring boards 1, 4 and 6, as shown in Figure 1, the outer diameter of the connecting lands 8, 9 of the first and second layer printed wiring circuits 2, 3 of the inner printed wiring board 1 are made larger than the diameter of the through hole 13, 14 of connecting lands 10, 11 of the first and second layer printed wiring boards 4, 6 and the diameter of the through holes 13, 14 of connecting lands 10, 11 of the first and second outer layer printed wiring boards 4, 6 are made larger than the diameter of the through holes 12 of the connecting lands 8, 9 of the inner layer printed wiring board 1 (larger than the diameter of the through hole 12 by at least 0.2 mm).

According to the above conditions of construction, the inner and outer printed wiring boards 1, 4 and 6 are provided in such a manner that the first and the second printed wiring circuits 2, 3 having connecting lands 8(10), 9(11) arranged thereon are provided by a known manufacturing process, for example, the method in which double-sided copper clad laminate having copper foils stretched on both sides of a base material is utilised as the inner printed wiring boards 1 and the copper foils on both sides are provided on the inner printed wiring boards 1, 4 and 6 by an etching process and the through hole 12 is formed by drilling. Similarly, the first and second outer layer printed wiring boards 4, 6 are provided in such a manner that third and fourth layer printed wiring circuits 5, 7 having connecting lands 10, 11 are formed by utilising a single-sided copper clad laminate and the through holes 13 and 14 are formed by drilling.

Then, as shown in Figure 1, respective inner and outer layer printed wiring boards 1, 4 and 6 are laminated and pasted.

That is, as shown in Figure 1, the first outer printed wiring board 4 is laminated on the upper side of the inner printed wiring board 1 and the second outer printed wiring board 6 is laminated on the lower side of the inner printed wiring board 1, during registering the centre of the respective connecting lands 8, 9, 10 and 11 of the respective printed wiring circuits 2, 3, 5 and 7 provided on the respective inner and outer layer printed wiring boards 1, 4 and 6 and the centre of the through holes 12, 13 and 14 of the respective inner and outer layer printed wiring boards 1, 4 and 6. As a bonding process, the pasting of the respective inner and outer layer printed wiring boards 1, 4 and 6 is performed by the mass lamination system using a prepreg.

That is, in such a bonding process, the respective inner and outer layer printed wiring boards 1, 4 and 6 are pasted under laminating conditions by heating and pressing after intervening and prepreg (not shown) among the respective inner and outer layer printed wiring boards 1, 4 and 6 in accordance with registration of the printed wiring boards.

The outer pasting process may be adopted as a bonding process.

After laminating and pasting the inner and outer layer printed wiring boards 1, 4 and 6 as described above, as shown in Figure 1, respective printed wiring circuits are electrically connected through the connecting lands 8, 9, 10 and 11 of the first to fourth layer printed wiring circuits 2, 3, 5 and 7 provided on the respective inner and outer layer printed wiring boards 1, 4 and 6, thereby manufacturing four layer printed wiring board 15.

In this case, the electrical connection of the connecting lands 8, 9, 10 and 11 is performed by soldering instead of plating.

That is, as shown in Figure 1, the respective connecting lands 8, 9, 10 and 11 are electrically connected in such a manner that a plurality of conductive wires 16 are inserted in the respective through holes 12, 13 and 14 of the respective connecting lands 8, 9, 10 and 11, and then molten solder 17 is filled into the through-holes 12, 13 and 14 using capillary action of the fine wires 16 and the solder 17 is solidified.

In an alternative process for filling the molten solder 17 in the through holes 12, 13 and 14 by means of capillary action of the fine wires 16, after the pasting process of the respective printed wiring boards, the printed wiring boards 1, 4 and 6 having the fine wires 16 inserted and set in the through holes 12, 13 and 14, may be immersed in a solder vessel (not shown) into which molten solder is filled.

Such a process is described concretely. As shown in Figure 1, the fine wires 16 are inserted and set in the through holes 12, 13 and 14 of the thus pasted inner and outer layer printed wiring boards 1, 4 and 6 (hereinafter referred to as a multilayer printed wiring board). The fine wire 16 is formed by a conductive member such as copper and a plurality of fine wires having a diameter smaller than that of the through hole are inserted therein. For example, if the diameter of the through hole 12 is 0.8 mm, the diameter of the fine wire 16 is made 50-100 mm and about 10-30 fine wires 16 are inserted in the through hole 12. In this case, it is preferable that the surface of the fine wire 16 may be subjected to flux treatment. The fine wire 16 is available as "winking wire CP-1515" (trade name) manufactured by Taiyo Electric Industries Ltd. Small gaps are formed among the fine wires 16 inserted in the through hole 12 and this gap causes capillary action between the fine wires 16. In the illustrated embodiment, the fine wire 16 has the same length as the sum of the thicknesses of the respective printed wiring boards 1, 4 and 6, but the length of the fine wire 16 is not limited so long as the fine wire 16 causes capillary action.

After inserting such a fine wire 16, the multilayer printed wiring board is immersed in the solder vessel (not shown). The solder vessel is filled with molten solder held at about 260°C, and then the molten solder is entered into the through holes 12, 13 and 14 by the immersion of the multilayer printed wiring boards into the solder vessel. In the entering of the solder, the molten solder is smoothly absorbed into the through holes 12, 13 and 14 by capillary action between the fine wires, so that the inner portion of the through holes 12, 13 and 14 are filled by the fine wires 16 and the molten solder and, as shown in Figure 1, the molten solder rises onto both connecting lands 10, 11. It is preferable to immerse the multilayer printed wiring board in the solder vessel for about 5 minutes in order to prevent thermal damage to the respective printed wiring boards 1, 4 and 6. Even with such a short immersion, the molten solder can be smoothly filled by capillary action between the fine wires 16, so that the molten solder can be filled in the through holes 12, 13 and 14.

The fine wire 16 and the solder 17 were filled in the through holes 12, 13 and 14 pulled up from the solder vessel and the solder 17 is contacted to the connecting lands 8, 9 under the states raised on the surface of the connecting lands 10, 11, so that respective connecting lands 8, 9, 10 and 11 are electrically connected with each other and surely conducted through the solder 17 and the fine wire 16 formed by the conductive materials.

In such an embodiment, the connecting lands 8, 9, 10 and 11 can be conducted only by the insertion of fine wire 16 into the through holes 12, 13 and 14 and the immersion of the multilayer printed wiring board into the solder vessel, so that the conduction between the connecting lands can be performed without performing troublesome treatments such as plating, printing and soldering, and thus fast and mass production can be obtained. Since the solder is absorbed in the through hole by capillary action, sufficient amount of solder is surely filled in the through hole, so that the connection improving reliability of conducting resistance can be performed.

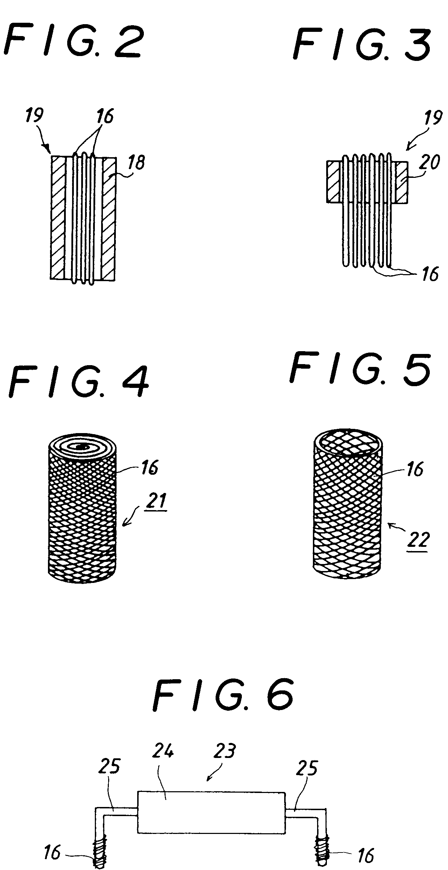

Figures 2 to 6 show modifications of the fine wires 16 inserted in the through holes 12, 13 and 14 of the multilayer printed wiring boards, respectively. In the modified embodiment shown in Figure 2, a plurality of fine wires 16 are inserted in a conductive short tube 18, and these fine wires 16 and the short tube 18 form a tubular body 19. If the tubular body 19 is inserted in the through hole, the short tube 18 is also inserted in the through holes 12, 13 and 14 and thus the fine wires 16 are inserted in the through hole together with the short tube 18. When the multilayer printed wiring board is immersed in the solder vessel under the inserting states of the tubular body 19, the solder is absorbed by capillary action between fine wires 16, so that a sufficient amount of the solder can be filled in the through hole.

In the embodiment shown in Figure 3, the short tube 20 having a length shorter than the short tube 18 of the tubular body 19 shown in Figure 2 is used. The length of the short tube 20 is not limited, so long as the fine wires 16 are surely and easily inserted in the through-holes 12, 13 and 14. Therefore, even in the short tube 20 shown in Figure 3, the fine wires 16 are easily inserted in the through hole by inserting it in the through hole from the short tube side.

Figure 4 shows an inserting body 21 made by spirally winding a mesh sheet formed by arranging the fine wires 16 in a meshed form, so that a capillary tube is formed between the meshed fine wires 16 and between the spiral mesh sheets. The thus-formed inserting body 21 is inserted in the through holes 12, 13 and 14, so that solder is absorbed in the through hole by the capillary action of the fine wires 16 and thus a sufficient amount of solder can be filled.

Figure 5 shows a tubular body 22 formed by winding the mesh sheet in a tubular shape. This tubular body 22 may be inserted in the through holes 12, 13 and 14 as it is, or may be inserted in the through hole under the state that the conductive fine wire 16 (not shown) is inserted in the tubular body 22, so that in any case, the solder can be absorbed in the through hole by the capillary action of the fine wires 16.

Figure 6 shows a state that the fine wire 16 is wound on the lead wires of an electronic component 23. The electronic component 23 is mounted on the multilayer printed wiring board 15, and comprises a package body 24 accommodating IC, LSI or other chips therein and a plurality of lead wires 25 extending from the package body 24, and mounted by inserting the respective lead wires 25 in the through holes 12, 13 and 14 of the multilayer printed wiring board 15. The fine wire 16 is wound on the tip portion of the lead wires 25 of the electronic component 23, and inserted in the through holes 12, 13 and 14 together with the lead wires 25, so that the filling of solder into the through hole is performed and due to the fixing of leads 25, the mounting of the electronic component 23 and the connecting of the connection lands 8, 9, 10 and 11 can be performed, simultaneously.

In case of performing the connecting lands 8, 9, 10 and 11 with the use of the lead of the mounting component, also the embodiment that the lead wires 15 of the component 23 itself is previously formed with a plurality of fine wires 16 (not shown) can be used instead of the embodiment that the fine wire 16 is wound on the lead wire shown in Figure 6.

The fine wire 16 previously subjected to solder plating is, also, used in the respective embodiments.

As described above, the multilayer (four layer) printed wiring board shown in Figure 1 can be manufactured. Moreover, in the above explanation, after respective forming processes of respective printed wiring boards 1, 4 and 6, the registration and pasting processes of respective printed wiring boards 1, 4 and 6 with each other are performed, and then the connecting process of the connection lands 8, 9, 10 and 11 is performed. However, prior to this connecting process, the portions other than the connection lands 10, 11 of the printed wiring circuits 5, 7 required to the connecting process of the first and the second outer layer printed wiring boards 4 and 6 are covered with solder resists 26, 27 and necessary marking printing processes or the like is performed.

Next, the shaping of the multilayer printed wiring board is completed by performing further necessary cutting, trimming and routing as well as surface treatment after applying flux, and the other necessary working and treatments.

As described above, the multilayer (4 layer) printed wiring board 15 shown in Figure 1 can be manufactured.

It is further understood by those skilled in the art that the foregoing description is a preferred embodiment of the disclosed device and that various changes and modifications may be made in the invention.

For example, the construction and shaping process of the inner and outer layer printed wiring boards 1, 4 and 6 in the above manufacturing method are not limited thereto, but can be performed by the construction and the shaping process according to the designs of pattern required to respective layers.

Moreover, the construction and the manufacturing method of the multilayer printed wiring board 15 of 4 layers itself are not limited to the previous embodiments, but can be adopted to the manufacture of multilayer printed wiring board of other than 4 layers with the same function and advantageous effect thereof. In the previous embodiment, further, as to the perforation of the respective through holes 12, 13 and 14 with reference to the respective shaping process of the respective inner and outer layer printed wiring boards 1, 4 and 6, the perforation working by drilling or the like can be carried out even after the lamination process due to bonding of respective printed wiring boards 1, 4 and 6 instead of respective perforation working.

For example, the inner layer printed wiring board 1 is subjected to a perforation process for the through hole 12 after forming printed wiring circuits 2, 3 due to the required pattern and after the bonding process of the other printed wiring boards 4, 6, and the first and the second outer layer printed wiring boards 4, 6 can be worked in either of before or after the bonding process, and the same can be adopted in the formation of the printed wiring board.

Similarly, the other multilayer printed wiring boards can be manufactured while performing design changing of various working processes.

As is seen from the previous embodiments, the electric connection of the printed wiring circuits 2, 3, 5 and 7 with each other of respective layers can be performed by soldering instead of plating, so that the cost of equipment can be decreased and the working environment and the management are improved as well as the difficulties of environmental sanitation can be resolved. At the same time, the outer diameter of the connection lands 8, 9 in structure of solder connection is made larger than the diameter of the through holes 13, 14 of the connection lands 10, 11 and the diameter of the through holes 13, 14 of the connection lands 10, 11 is made larger than that of the through hole 12 of the connection lands 8, 9, so that the area in which the surface area of the connection lands 8, 9 exposed at the opening portion of the through holes 13, 14 is added to the thickness of its copper foil, is a contacting area due to the soldering, and thus the reliability of the conductivity due to soldering at the same portion can be improved, since in the conventional method, the contacting area is limited by the thickness of the copper foil of respective circuits in the case of the connection due to the through hole plating.

According to the manufacturing method of the multilayer printed wiring board of the present invention, the simplifying of the manufacture, low price and improvement of the reliability and quality can be achieved.

## Claims

1. A method of manufacturing multilayer printed wiring board, in which respective layers of the multilayer printed wiring board are formed with respective printed wiring boards, respective printed wiring boards are laminated and pasted up, and necessary circuits of the printed wiring board are electrically connected by means of through holes punched into respective printed wiring boards, the method comprising the steps of:-
making the outer diameter of a connecting land of the printed wiring board positioned at an inner layer of the respective printed wiring boards forming respective layers, larger than the through hole diameter of connecting lands of the printed wiring board positioned at an outer layer of the respective printed wiring boards;
making the through hole diameter of connecting lands of the printed wiring board positioned at an outer layer of the respective printed wiring boards larger than the through hole diameter of the connecting land of the printed wiring board positioned at an inner layer of the respective printed wiring boards;
inserting a plurality of fine wires into respective through holes punched in the respective printed wiring boards;
filling solder into the through holes of the connecting lands by capillary action; and
electrically connecting necessary circuits between the respective printed wiring boards with each other.

2. A method of manufacturing multilayer printed wiring board as claimed in claim 1, wherein the plurality of fine wires inserted into respective through holes punched in the respective printed wiring boards are formed by a tubular body which comprises a conductive short tube and a plurality of fine wires.

3. A method of manufacturing multilayer printed wiring board as claimed in claim 1, wherein the plurality of fine wires inserted into respective through holes punched in the respective printed wiring boards are formed by an inserting body which comprises a mesh sheet formed by arranging the fine wires in a meshed form.

4. A method of manufacturing multilayer printed wiring board as claimed in claim 1, wherein the fine wire is wound on the lead wires of an electronic component.

5. A method of manufacturing multilayer printed wiring board as claimed in claim 3, wherein the plurality of fine wires inserted into respective through holes punched in the respective printed wiring boards are formed by a tubular body formed by winding the mesh sheet in a tubular shape.

6. A method of manufacturing multilayer printed wiring board as claimed in claim 2, wherein the plurality of fine wires inserted into respective through holes punched in the respective printed wiring boards are formed by a tubular body which comprises a conductive short tube having a length shorter than that of the short tube of the tubular body and a plurality of fine wires.
